(19) Europäisches Patentamt
European Patent Office
Office européen des brevets

(11) Publication number: **0 201 903 B1**

(12) # EUROPEAN PATENT SPECIFICATION

(45) Date of publication of patent specification: **07.08.91** (51) Int. Cl.$^5$: **C08F 2/50**

(21) Application number: **86106431.9**

(22) Date of filing: **12.05.86**

The file contains technical information submitted after the application was filed and not included in this specification

(54) **Photopolymerizable composition.**

(30) Priority: **13.05.85 JP 99545/85**
**14.05.85 JP 100478/85**
**16.07.85 JP 156753/85**
**07.10.85 JP 223324/85**

(43) Date of publication of application:
**20.11.86 Bulletin 86/47**

(45) Publication of the grant of the patent:
**07.08.91 Bulletin 91/32**

(84) Designated Contracting States:
**CH DE FR GB IT LI**

(56) References cited:
**EP-A- 28 749**
**EP-A- 155 812**

(73) Proprietor: **MITSUBISHI RAYON CO., LTD.**
**3-19, Kyobashi 2-chome Chuo-Ku**
**Tokyo 104(JP)**

(72) Inventor: **Sasaki, Isao**
**1655-98, Ohno-cho**
**Saiki-gun Hiroshima(JP)**
Inventor: **Mukai, Nobuhiro**
**2-6-203, Kurokawa 3-chome**
**Ohtake-shi Hiroshima(JP)**
Inventor: **Ige, Hitoshi**
**36-16, Nishisakae 3-chome**
**Ohtake-shi Hiroshima(JP)**

(74) Representative: **Bühling, Gerhard, Dipl.-Chem. et al**
**Patentanwaltsbüro Tiedtke-Bühling-Kinne Grupe-Pellmann-Grams-Struif Bavariaring 4**
**W-8000 München 2(DE)**

**EP 0 201 903 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

BACKGROUND OF THE INVENTION

(1) Field of the Invention

This invention relates to a novel photopolymerizable composition. More specifically, it relates to a photopolymerizable composition having excellent storage stability, with less coloration and capable of obtaining cured products having high mechanical performance.

(2) Description of the Related Art

Photopolymerization has been utilized in a wide variety of applications such as for image formation in fine fabrication processes, for example, for print materials, photosensitive agents for reproduction, printed wirings, IC and shadow masks; as well as for paints, printing inks, adhesives and the like.

Polymerization has also been utilized in the dental field, for example, photopolymerizable compositions have been used for the production of a tooth filler (composite resin, etc), tooth sealing material and dental adhesives, as well as for the production of carious tooth preventive fillers, tooth crowns and denture.

As the photopolymerizable compositions having been utilized heretofore as described above, Japanese Patent Publication No. 10986/1979, for instance, describes a photopolymerizable composition curable under the irradiation of visible light or ultraviolet light and having a specific composition. The photopolymerizable composition comprises a photoinitiator complex of a photosensitive agent/a reducing agent, that is, a photosensitive catalyst composed of (a) at least one photosensitive agent represented by the following general formula:

$$A-\underset{\underset{O}{\|}}{C}-(X)_{\ell}-A$$

where X represents C = 0, $CR_1'R_2'$ or $CR_3'OR_4'$ (wherein $R_1'$ through $R_4'$ which may be identical or different represent hydrogen or a hydrocarbon group), ℓ is 0 or 1, the groups A which may be identical or different represent substituted or unsubstituted hydrocarbon groups, in which both of the groups A may be coupled directly or joined together by way of a bivalent hydrocarbon group, or both of the groups A may form together a condensated aromatic ring, and the group A is substituted or unsubstituted aromatic group when ℓ is 1 and X represents $CR_1'R_2'$ or when ℓ is 0, (b) at least one reducing agent represented by the following general formula:

$$R-\overset{\overset{R}{|}}{N}-R$$

where the units R which may be identical or different represent hydrogen, substituted or unsubstituted hydrocarbon groups or two units R may form a ring together with N, provided that three units R are not simultaneously substituted hydrocarbon groups, and N is not directly coupled to the aromatic group, and (c) a polymerizable ethylenically unsaturated material. Specific examples of particularly preferred photosensitive agents can include biacetyl, benzyl, benzophenone, and camphorquinone. As the reducing agent, there can be mentioned trimethylamine, tripropylamine, demethylamine, propylamine, N,N'-dimethylaniline, N-methyldiphenylamine, ethylenediamine, hexamethylenediamine, dimethylaminoethyl methacrylate, piperidine, and the like. Although the materials using these photoinitiators can provide rapid curing under photoirradiation, there have been serious practical problems in that the cured products suffer from remarkable discoloration (mostly yellowing), a significant aging change of the color under sunlight and in water, and exhibit an inferior strength. Further, the composition has an extremely low storage stability under heat and circumstantial light (natural light), which results in a spontaneous curing.

SUMMARY OF THE INVENTION

The object of this invention is to overcome the foregoing problems in the prior art and provide a

photopolymerizable composition having excellent storage stability under heat and circumstantial light, with no discoloration and aging change for the tone and providing products with excellent mechanical performances. In accordance with the present invention, there is provided a photopolymerizable composition comprising a vinyl monomer and a photopolymerization initiator, said vinyl monomer being selected from styrene, acrylonitrile, vinyl acetate, methyl acrylate, methyl methacrylate, ethyl acrylate, ethyl methacrylate, butyl acrylate, butyl methacrylate, hydroxyethyl acrylate, hydroxyethyl methacrylate, methoxyethyl acrylate, methoxyethyl methacrylate, glycidyl acrylate, glycidyl methacrylate, ethylene glycol di-acrylate, ethylene glycol di-methacrylate, diethylene glycol di-acrylate, diethylene glycol di-methacrylate, triethylene glycol di-acrylate, triethylene glycol di-methacrylate, polyethylene glycol di-acrylate, polyethylene glycol di-methacrylate, 1,4-butane-diol di-acrylate, 1,4-butane-diol di-methacrylate, 1,3-butane-diol di-acrylate, 1,3-butane-diol di-methacrylate, 1,6-hexane-diol di-acrylate, 1,6-butane-diol di-methacrylate, glycerin di-acrylate or di-methacrylate of the following general formula:

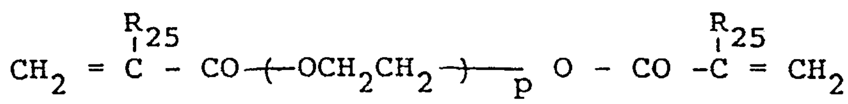

where $R_{25}$ represents a hydrogen atom or methyl group and p is an integer from 1 to 20, bisphenol A diglycidyl acrylates, bisphenol A diglycidyl methacrylates, urethane di-acrylates, urethane di-methacrylates, trimethylolpropane tri-acrylate, trimethyl-olpropane tri-methacrylate, pentaerythritol tetra-acrylate, pentaerythrytol tetra-methacrylate, bis-phenol A di-acrylate or di-methacrylate represented by the following general formula:

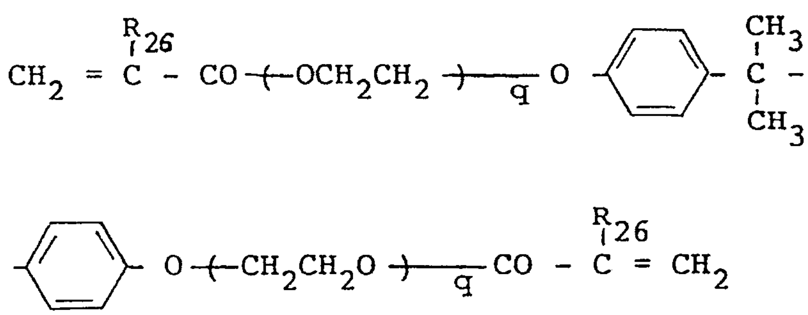

where $R_{26}$ represents a hydrogen atom or methyl group and q is an integer from 1 to 20, wherein said photopolymerization initiator is a combination of (a) at least one compound selected from a mercaptocarboxylic acid, a polysulfide and a thiophosphoric derivative with (b) camphorquinone.

## DESCRIPTION OF THE PREFERRED EMBODIMENTS

The vinyl monomer of this invention may be either a mono-functional vinyl compound or a poly-functional vinyl compound. The mono-functional vinyl compound includes, for example, styrene, acrylonitrile, vinyl acetate, methyl acrylate, methyl methacrylate, ethyl acrylate, ethyl methacrylate, butyl acrylate, butyl methacrylate, hydroxyethyl acrylate, hydroxyethyl methacrylate, methoxyethyl acrylate, methoxyethyl methacrylate, glycidyl acrylate and glycidyl methacrylate Further, the poly-functional vinylic compound includes, for example, ethylene glycol di-acrylate and ethylene glycol di-methacrylate, diethylene glycol di-acrylate and diethylene glycol di-methacrylate, triethylene glycol di-acrylate and triethylene glycol di-methacrylate, polyethylene glycol di-acrylate and polyethylene glycol di-methacrylate, 1,4-butane-diol di-acrylate and 1,4-butane-diol di-methacrylate, 1,3-butane-diol di-acrylate and 1,3-butane-diol di-methacrylate,1,6-hexane-diol di-acrylate and 1,6-butane-diol di-methacrylate, glycerin di-acrylate and glycerin di-methacrylate of the following general formula:

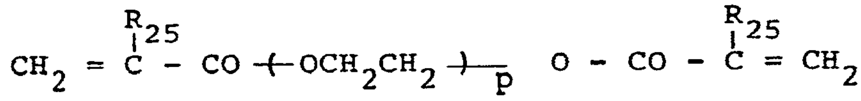

where $R_{25}$ represents a hydrogen atom or methyl group and p is an integer from 1 to 20, as well as bisphenol A diglycidyl acrylates and bisphenol A diglycidyl methacrylates, urethane di-acrylates and urethane di-methacrylates, trimethylolpropane tri-acrylate and trimethylolpropane tri-methacrylate, pentaerythritol tetra-acrylate and pentaerythritol tetra-methacrylate, bisphenol A di-acrylate and bisphenol A di-methacrylate represented by the following general formula:

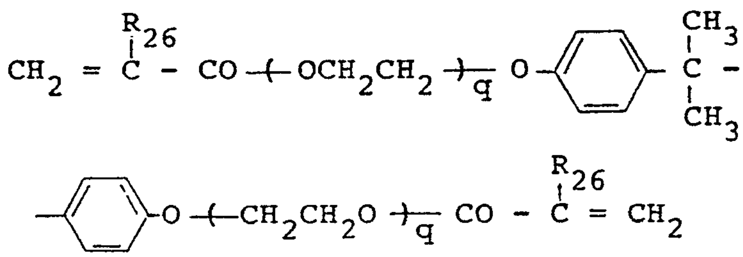

where $R_{26}$ represents a hydrogen atom or methyl group and q is an integer from 1 to 20. These acrylates and methacrylates may be used alone or in a combination of two or more thereof.

The mercaptocarboxylic acid used as the photopolymerization initiator in this invention is preferably a compound represented by the following general formula:

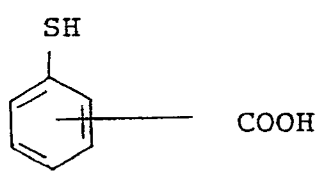
or
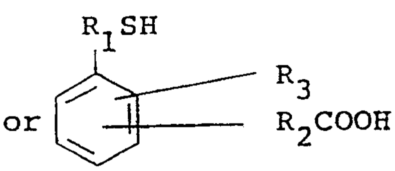

where $R_1$ and $R_2$ independently represent an alkylene group from 1 to 5 carbon atoms or phenylene group, $R_3$ represents a nitro group, a hydroxy group, an amino group or a halogen atom. Specifically, they include o-, m- and p-mercaptobenzoic acid, o-, m- and p-mercaptophenyl acetic acid, o-, m- and p-mercaptophenyl propionic acid, o-, m-, and p-mercaptophenyl butyric acid, mercaptobiphenyl carboxylic acid, o-, m- and p-mercaptomethyl benzoic acid, o-nitro-p-mercapto benzoic acid, o-hydroxy-p-mercapto benzoic acid, o-amino-p-mercapto-benzoic acid and o-chloro-p-mercapto-benzoic acid. Particularly, the preferred mercaptocarboxylic acids are o-mercaptobenzoic acid (thiosalycilic acid), m-mercaptobenzoic acid, and p-mercaptobenzoic acid.

The polysulfide used as the photopolymerization initiator in this invention is a compound, preferably represented by the following formula:

$$R_4 - S - (S)_m - S - R_4$$

where;

m is an integer from 0 to 10;

$R_4$ is a saturated or unsaturated alkyl group having 1 to 20 carbon atoms, a phenyl or a benzyl group, each of which may be unsubstituted or substituted with a carboxylic group at any position. Specific examples can include, for example, dimethyl disulfide, diethyl disulfide, dipropyl disulfide, dibutyl disulfide, diphenyl disulfide, dibenzyl sulfide, trimethylene disulfide, dimethyl trisulfide, diethyl trisulfide, dipropyl trisulfide, dibutyl trisulfide, diphenyl trisulfide, dibenzyl trisulfide, p-(phenyl disulfanil)benzoic acid, and 3,3'-trithiodipropionic acid. Particularly preferred polysulfide can include, for example, diphenyl disulfide, dibenzyl disulfide, di-t-butyl disulfide, trimethylene disulfide, p-(phenyl disulfanil) benzoic acid, diphenyl trisulfide, and dibenzyl trisulfide.

It is preferable that the thiophosphoric acid derivative used in this invention be a monothiophosphoric

compound represented by the general formula

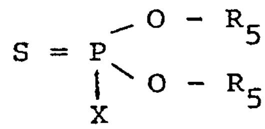

(Where, $R_5$ represents a hydrogen atom, an alkali metal or an alkyl group containing 1 to 20 carbon atoms and X represents a halogen atom.), a dithiophosphoric diester represented by the general formula:

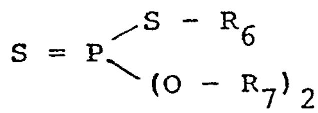

(Where, $R_6$ is a hydrogen, an alkali metal, a copper atom or a zinc atom and $R_7$ is an alkyl group containing 1 to 20 carbon atoms.) or a dithiophosphoric triester represented by the general formula

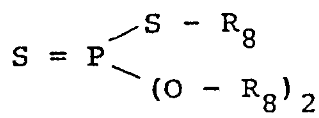

(Where, $R_8$ represents an alkyl group containing 1 to 20 carbon atoms.). Specific examples can include, for example, monothiophosphoric compounds such as trioleyl thiophosphate, tris (2,3-dichloropropyl) thiophosphate, O,O'-diethylthiophosphoryl chloride, O,O'-diisopropylthiolphosphate and sodium diamylmonothiophosphate, dithiophosphoric diesters such as O,O'-diethyldithiophosphate, sodium dipropyldithiophosphate, zinc dipropyldithiophosphate and copper O,O'-di(2-ethylhexyl) dithiophosphate and dithiophosphoric triesters such as O,O'-di-n-butyl-s-ethyldithiophosphate and O,O'-dimethyl-dithiophosphoryl acetate.

Any one of these thiophosphoric derivatives or any combination of at least two of these compounds can be combined with an α-diketone.

The photopolymerization initiator is added to the above-mentioned vinyl monomer by an amount from $10^{-5}$% by weight to 30% by weight, preferably, from $10^{-3}$% by weight to 15% by weight and, particularly preferably, from $10^{-1}$% by weight to 5% by weight based on the monomer. The amount of the camphorquinone blended to the above-mentioned vinyl monomer is from $10^{-5}$% by weight to 30% by weight, preferably, from $10^{-3}$% by weight to 10% by weight and particularly preferably, from $10^{-2}$% by weight to 3% by weight based on the vinyl monomer.

These blending amounts are suitable in that the photopolymerization curing product is free from discoloration and aging change in the color, and further, a composition having a high mechanical strength can be obtained.

The storage stabilizer used preferably in this invention is added to significantly reduce the curing of the composition comprising the vinyl monomer and the photopolymerization initiator, under heating and circumstantial light. The storage stabilizer used in this invention can include the following.

(A) A triazine compound represented by the general formula:

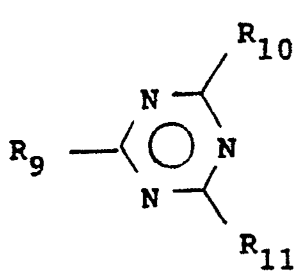

where $R_9$, $R_{10}$ and $R_{11}$ independently represent a hydrogen atom, a halogen atom, an alkyl group having 1 to 20 carbon atoms, a hydroxy group, an alkoxy group having 1 to 20 carbon atoms, a phenoxy group, an alkyl peroxy group having 1 to 20 carbon atoms, an amino group represented by $NR_{12}R_{13}$ in which $R_{12}$ and $R_{13}$ independently represent a hydrogen atom, an alkyl group having 1 to 20 carbon atoms or aromatic group having 6 to 20 carbon atoms, and derivatives thereof, or a thio group represented by $SR_{14}$ in which $R_{14}$ represents a hydrogen atom or a alkyl group having 1 to 20 carbon atoms, for example, 2,4-bis-(n-octylthio)-6-(4-hydroxy-3,5-di-tert-butylanilino)-1,3,5-triazine, 2-(N,N-dibutylamino)-4,6-dimercapto-1,3,5-triazine and 2-anilino-4,6-dimercapto-1,3,5-triazine.

(B) A benzotriazole compound represented by the general formula:

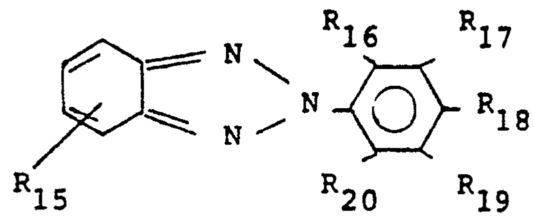

where $R_{15}$ represents hydrogen atom or a halogen atom, $R_{16}$, $R_{17}$, $R_{18}$, $R_{19}$ and $R_{20}$ independently represent a hydrogen atom, a hydroxy group, an alkyl group having 1 to 10 carbon atoms, or benzyl group and derivatives thereof, for example, 2-(5-methyl-2-hydroxyphenyl)benzotriazole, 2-(2-hydroxy-3,5-bis(α,α-dimethylbenzyl)phenyl)benzotriazole, 2-(3,5-di-tert-butyl-2-hydroxyphenyl)benzotriazole, 2-(3-tert-butyl-5-methyl-2-hydroxyphenyl)-5-chlorobenzotriazole, 2-(3,5-di-tert-butyl-2-hydroxyphenyl-5-chlorobenzotriazole, or 2-(3,5-di-tert-amyl-2-hydroxyphenyl)benzotriazole.

(C) Oxalic acid anilide compounds, for example, 2-ethoxy-2'-ethyloxalic acid anilide, 2-ethoxy-5-tert-butyl-2'-ethyloxalic acid bisanilide.

(D) Hindered amine compounds, for example, poly-condensate of dimethyl-1-(2-hydroxyethyl)-4-hydroxy-2,6,6,6-tertramethylpiperidinesuccinate, (poly((6-(1,1,3,3-tetramethylbutyl)imino-1,3,5-triazine-2,4-di-yl) (-(2,2,6,6,-tertramethyl-4-piperidyl)imino)hexamethylene ((2,2,6,6-tetramethyl-4-piperidyl)imino)), 2-(3,5-di-tert-butyl-4-hydroxybenzyl)-2-n-butyl malonic acid bis(1,2,2,6,6-pentamethyl-4-piperidyl).

(E) Thiuram sulfide compounds represented by the general formula:

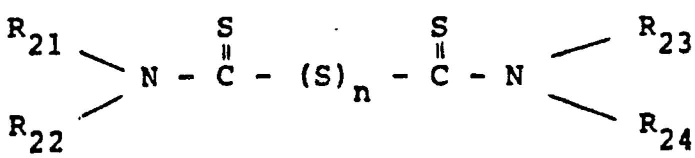

where $R_{21}$, $R_{22}$, $R_{23}$ and $R_{24}$ independently represent a hydrogen atom or an alkyl group having 1 to 10 carbon atoms and n is an integer from 1 to 4, for example, tetraethylthiuram disulfide, tetramethylthiuram disulfide, or tetrakis(2-ethylhexyl)thiuram disulfide. Among these compounds, particularly preferred in view of the color, storage stability, and mechanical properties of the cured product, are 2,4-bis-(n-octylthio)-6-(4-hydroxy-3,5-di-tert-butylanilino)-1,3,5-triazine, 2-(5-methyl-2-hydroxyphenyl)-benzotriazole and tetraethylthiuram disulfide.

The above-mentioned storage stabilizer can be used singly or as a combination of two or more, and the amount thereof relative to the above-mentioned vinyl monomer is from $10^{-3}$% by weight to 10% by weight, preferably, from $10^{-2}$% by weight to 5% by weight, and particularly preferably, from 5 x $10^{-2}$% by weight to 1% by weight.

In the composition according to this invention, a filler may be further added to the above-mentioned ingredients as required. The filler ingredient can include metals belonging to the groups I, II, III, IV, and V and transition metals of the periodical table, oxides, hydroxides, chlorides, sulfates, sulfite, carbonates, phosphates, silicates, as well as mixtures and complex salts thereof. Particularly preferred are silicone dioxide, quartz powder, aluminum oxide, barium sulfate, titanium oxide, talc, glass powder, glass bead, glass fillers containing barium salt and lead salt, silica gel, colloidal silica, carbon fibers, zirconium oxides, tin oxides and other ceramics powders. The above-mentioned fillers may be non-treated fillers, surface treated fillers with a silane coupling agent or the like, or organic compound fillers compounded with a

polymer and then pulverized.

The blending amount of the filler may be properly varied depending on the purpose of use for the photopolymerized curing product. For instance, where the filler is used as the filler for dental material, it is blended to the above-mentioned vinyl monomer within a range from 1 to $10^3$% by weight, preferably, from 10 to 9.5 x $10^{-2}$% by weight, and particularly preferably, from 20 to 9 x $10^2$% by weight, into a paste-like composition.

Furthermore, the composition according to this invention also may be blended as required with colorants, polymerization inhibitors (for example, hydroquinone, methoxybenzophenone, methylphenol, hydroquinonemonomethyl ether), oxidation stabilizers, UV absorbers (for example, benzophenone), pigments (for example, iron oxide, and titanium oxide), dyes and the like.

Since a photopolymerization initiator capable of curing within the range of visible rays is used in the photopolymerizable composition according to this invention, all of the problems in the prior art for UV-photopolymerization, that is, deleterious effect to human bodies, poor curing performance (depth), and expensive installation cost, can be avoided, and further, the cured product obtained through the photocuring has an excellent color stability and a high mechanical performance that could not be obtained in the prior method, and further, the composition according to this invention exhibits an extremely high storage stability.

This invention will now be described more specifically by referring to examples, but the invention is not limited to these examples.

Examples 1 - 3, Comparative Examples 1 - 2

A monomer mixture comprising:

2,2-bis(4-(3-methacryloxy-2-hydroxypropoxy)phenyl)propane(hereinafter simple referred to as Bis-GMA) ... 4 g

Triethyleneglycol dimethacrylate (hereinafter simple referred to as "3G") ... 6 g

Photopolymerization initiator (compounds and the addition amount listed in Table 1)

was poured into a Teflon tube (4 mm inner diameter, 20 mm height), sealed at the bottom until the upper surface of the solution was level with the upper surface of the Teflon tube. The Teflon tube was disposed such that the liquid level was situated at a distance of 1 mm from the light irradiation surface of a visible light irradiator (manufactured by 3M Corporation, Trade name: OPTILUX) and visible rays were irradiated for 30 seconds. The poured monomer mixture was recovered from the Teflon tube, removed with a non-polymerized porticn, and the "thickness" was measured for the thus-obtained polymerization curing product.

Table 1 shows the kind and amount of the photoinitiator, as well as the result of the measurement of the foregoing "thickness".

Table 1

| | Photoinitiator | Addition amount (%) (based on monomer) | Thickness measured (mm) |
|---|---|---|---|
| Example 1 | thiosalicyclic acid + camphorquinone | 3.0<br>0.05 | more than 20 |
| Example 2 | m-mercaptobenzoic acid + camphorquinone | 3.0<br>0.05 | more than 20 |
| Example 3 | p-mercaptobenzoic acid + camphorquinone | 3.0<br>0.05 | more than 20 |
| Comparative Example 1 | camphorquinone | 0.05 | 4.0 |
| Comparative Example 2 | N,N'-dimethylaniline + camphorquinone | 3.0<br>0.05 | 13.8 |

As apparent from Table 1, the compositions according to this invention have an excellent photocuring performance as compared with the known compositions of the comparative examples. Furthermore, the photocuring polymerizates according to this invention suffered no substantial discoloration, and were remarkably finer as compared with those of the comparative examples.

Example 4-6

A monomer mixture comprising:

Bis-GMA ... 4 g
3G ... 6 g
Photopolymerization initiator
(thiosalicylic acid ... 3.0% by weight
camphor quinone ... 0.05% by weight
each based on the monomer)
Storage stabilizer
(compounds and the amount thereof are listed in Table 2)

was polymerized and evaluated in the same manner as described in Examples 1 - 3.

Table 2 shows the kind and amount of the photoinitiator, as well as the results of the measurement of the foregoing "thickness".

Further, the monomer mixture of the same composition as described above was also prepared separately and poured into two vessels made of polypropylene (30 cc volume) each by 5 g. One of the samples was placed in a dark room at 60 °C after tightly closing the cover and the other of the samples was

placed under circumstantial light at ambient temperature without closing the cover to measure the storage stability until they were spontaneously cured.

Table 2 shows the kind and amount of the storage stabilizer, and the results of the measurement of the above-mentioned "thickness" and storage stability.

Table 2

| | Kind of storage stabilizer | Addition amount (%, based on monomer) | Thickness measured (mm) | Storage stability | |
|---|---|---|---|---|---|
| | | | | days of curing 60°C in the dark room | curing time at ambient temp. under circumstantial light |
| Example 4 | 2,4-bis-(n-octylthio)-6-(4-hydroxy-3,5-di-tert-butylanilino)-1,3,5-triazine | 0.1 | greater than 20 | more than 14 days | 10 hrs |
| Example 5 | 2-(5-methyl-2-hydroxy-phenyl)benzotriazole | 0.1 | greater than 20 | more than 14 days | 10 hrs |
| Example 6 | Tetraethylthiuram disulfide | 0.1 | greater than 20 | more than 14 days | 10 hrs |

As apparent from Table 2, it can be seen that the composition according to this invention exhibits a good photocuring performance even if the storage stabilizer is added and has an excellent storage stability. Further, the photocuring polymerizate according to this invention was substantially free from discoloration and much finer in appearance.

Example 7 - 13

A monomer mixture comprising:

| | |
|---|---|
| Bis-GMA | ... 4 g |
| 3G | ... 6 g |
| Photopolymerization initiator (Compounds and the addition amount are listed in Table 3) | |

was polymerized and evaluated in the same manner as described in Examples 1 - 3.

Table 3 shows the kind and amount of the photoinitiator, as well as the results of the measurement of the foregoing "thickness".

Table 3

| | Photoinitiator | Addition amount (%) (based on monomer) | Thickness measured (mm) |
|---|---|---|---|
| Example 7 | diphenyl disulfide + camphorquinone | 3.0<br>0.05 | more than 20 |
| Example 8 | dibenzyl disulfide + camphorquinone | 3.0<br>0.05 | " |
| Example 9 | di-t-butyl disulfide + camphorquinone | 3.0<br>0.05 | " |
| Example 10 | trimethylene disulfide + camphorquinone | 3.0<br>0.05 | " |
| Example 11 | p-(phenyldisulfanil) benzoid acid + camphorquinone | 3.0<br>0.05 | " |
| Example 12 | diphenyl trisulfide + camphorquinone | 3.0<br>0.05 | " |
| Example 13 | dibenzyl trisulfide + camphorquinone | 3.0<br>0.05 | " |

As apparent from Table 3, the compositions according to this invention have an excellent photocuring performance. Furthermore, the photocuring polymerizates according to this inventiOn did not suffer substantial discoloration, and were remarkably finer.

Example 14 - 16

A monomer mixture comprising:

| | |
|---|---|
| Bis-GMA | ... 4 g |
| 3G | ... 6 g |

Photopolymerization initiator
(diphenyl disulfide ... 3.0 by weight
camphorquinone ... 0.05 by weight
each based on the monomer)
Storage stabilizer
(Compounds and the addition amount are listed in Table 4)

was polymerized and evaluated in the same manner as described in Examples 4 - 6.

Table 4 shows the kind and amount of the photoinitiator, as well as the results of the measurement for the above-mentioned "thickness" and storage stability.

Examples 17 - 26

A monomer mixture comprising:

| | |
|---|---|
| Bis-GMA | ... 4 g |
| 3G | ... 6 g |

Photopolymerization initiator
(Compounds and the addition amount are listed in Table 5)

was polymerized and evaluated in the same manner as described in Examples 1 - 3.

Table 5 shows the kind and amount of the photoinitiator, as well as the results of the measurement of the foregoing "thickness".

Table 4

| | Kind of storage stabilizer | Addition amount (%, based on monomer) | Thickness measured (mm) | Storage stability | |
|---|---|---|---|---|---|
| | | | | days of curing 60°C in the dark room | curing time at ambient temp. under circumstantial light |
| Example 14 | 2,4-bis-(n-octylthio)-6-(4-hydroxy-3,5-di-tert-butylanilino)-1,3,5-triazine | 0.1 | greater than 20 | more than 14 days | 10 hrs |
| Example 15 | 2-(5-methyl-2-hydroxy-phenyl)benzotriazole | 0.1 | greater than 20 | more than 14 days | 10 hrs |
| Example 16 | Tetraethylthiuram disulfide | 0.1 | greater than 20 | more than 14 days | 10 hrs |

As apparent from Table 4, it can be seen that the composition according to this invention exhibits an excellent photocuring performance even if the storage stabilizer is added and has an excellent storage stability. Further, the photocuring polymerizate according to this invention was substantially free from discoloration and extremely fine and uniform in appearance.

Table 5

| | Photoinitiator | Addition amount (%) (based on monomer) | Thickness measured (mm) |
|---|---|---|---|
| Example 17 | Trioleyl thiophosphate + Camphorquinone | 3.0<br>0.05 | more than 20 |
| Example 18 | Tris(2,3-dichloropropyl) thiophosphate + Camphorquinone | 3.0<br>0.05 | " |
| Example 19 | O,O'-diethylthiophosphoryl chloride + Camphorquinone | 3.0<br>0.05 | " |
| Example 20 | O,O'-diisopropylthiol phosphate + Camphorquinone | 3.0<br>0.05 | " |
| Example 21 | Sodium diamylmonothiophosphate + Camphorquinone | 3.0<br>0.05 | " |
| Example 22 | O,O'-diethyl dithiophosphate + Camphorquinone | 3.0<br>0.05 | " |
| Example 23 | Sodium dipropyldithiophosphate + Camphorquinone | 3.0<br>0.05 | " |
| Example 24 | Zinc dipropyldithiophosphate + Camphorquinone | 3.0<br>0.05 | " |
| Example 25 | O,O'-di-n-butyl-s-ethyldithiophosphate + Camphorquinone | 3.0<br>0.05 | " |
| Example 26 | O,O'-dimethyl-dithiophosphoryl acetate + Camphorquinone | 3.0<br>0.05 | " |

As apparent from Table 5, the compositions according to this invention have an excellent photocuring performance. Furthermore, the photocuring polymerizates according to this invention suffered no substantial discoloration, and were remarkably fine.

Examples 27 - 29

A monomer mixture comprising:

Bis-GMA ... 4 g
3G ... 6 g
Photopolymerization initiator
(O,O'-diethyldithiophosphate ... 3.0% by weight
camphorquinone ... 0.05% by weight
each based on the monomer)
Storage stabilizer
(Compounds and the addition amount are listed in Table 6)

was polymerized and evaluated in the same manner as described in Examples 4 - 6.

Table 4 shows the kind and amount of the photoinitiator, as well as the results of the measurement of the above-mentioned "thickness" and storage stability.

Table 6

| | Kind of storage stabilizer | Addition amount (%, based on monomer) | Thickness measured (mm) | Storage stability | |
|---|---|---|---|---|---|
| | | | | days of curing 60°C in the dark room | curing time at ambient temp. under circumstantial light |
| Example 27 | 2,4-bis-(n-octylthio)-6-(4-hydroxy-3,5-di-tert-butylanilino)-1,3,5-triazine | 0.1 | greater than 20 | more than 14 days | 10 hrs |
| Example 28 | 2-(5-methyl-2-hydroxy-phenyl)benzotriazole | 0.1 | greater than 20 | more than 14 days | 10 hrs |
| Example 29 | Tetraethylthiuram di-sulfide | 0.1 | greater than 20 | more than 14 days | 10 hrs |

As apparent from Table 6, it can be seen that the composition according to this invention exhibits a good photocuring performance even if the storage stabilizer is added and has an excellent storage stability. 25 Further, the photocuring polymerizate according to this invention was substantially free from discoloration and much finer in the appearance.

Examples 30 - 32, Comparative Examples 3 - 4

A monomer filler mixture (paste) comprising:

```
Bis-GMA                                   ... 0.8 g
3G                                        ... 1.2 g
Silane modified quartz powder             ... 8 g
Photopolymerization initiator
(Compounds and the addition amount and listed
in Table 7)
```

was polymerized and evaluated in the same manner as described in Examples 1 - 3.

Table 7 shows the kind and amount of the photoinitiator, as well as the results of the measurement of the foregoing "thickness".

Table 7

| | Photoinitiator | Addition amount (%) (based on monomer) | Thickness measured (mm) |
|---|---|---|---|
| Example 30 | Thiosalicylic acid + camphorquinone | 3.0<br>0.05 | 12.0 |
| Example 31 | m-mercaptobenzoic acid + camphorquinone | 3.0<br>0.05 | 11.5 |
| Example 32 | p-mercaptobenzoic acid + camphorquinone | 3.0<br>0.05 | 12.0 |
| Comparative Example 3 | camphorquinone | 0.05 | 1.2 |
| Comparative Example 4 | N,N'-dimethylaniline + camphorquinone | 3.0<br>0.05 | 5.6 |

As apparent from Table 7, the compositions according to this invention have an excellent photocuring performance also in the case where the filler is added, as compared with the known compositions of the comparative examples. Furthermore, the photocuring polymerizate according to this invention suffered no substantial discoloration, and was remarkably finer as compared with that of the comparative examples.

Examples 33 - 35

A monomer-filler mixture (paste) comprising:

Bis-GMA ... 0.8 g
3G ... 1.2 g
Silane-modified quartz powder ... 8 g
Photopolymerization initiator
(thiosalicyclic acid ... 3.0% by weight
camphorquinone ... 0.05% by weight
each based on the monomer)
Storage stabilizer
(Compounds and the addition amount are listed in Table 8)

was polymerized and evaluated in the same manner as described in Example 4 - 6.

Table 8 shows the kinds and amount of the photoinitiator, and the result of the measurement of the storage stability and thickness.

Table 8

| | Kind of storage stabilizer | Addition amount (%, based on monomer) | Thickness measured (mm) | Storage stability | |
|---|---|---|---|---|---|
| | | | | days of curing 60°C in the dark room | curing time at ambient temp. under circumstantial light |
| Example 33 | 2,4-bis-(n-octylthio)-6-(4-hydroxy-3,5-di-tert-butylanilino)-1,3,5-triazine | 0.1 | 12.2 | more than 14 days | 10 hrs |
| Example 34 | 2-(5-methyl-2-hydroxy-phenyl)benzotriazole | 0.1 | 12.2 | more than 14 days | 10 hrs |
| Example 35 | Tetraethylthiuram disulfide | 0.1 | 12.1 | more than 14 days | 10 hrs |

As apparent from Table 8, it can be seen that the composition according to this invention exhibits an excellent photocuring performance even if the filler is added and has an excellent storage stability. Further, the photocuring polymerizate according to this invention was substantially free from discoloration and extremely fine and uniform in appearance.

Example 36 - 42

A monomer-filler mixture (paste) comprising:

| | |
|---|---|
| Bis-GMA | ... 0.8 g |
| 3G | ... 1.2 g |
| Silane-modified quartz powder | ... 8 g |
| Photopolymerization initiator | |
| (Compounds and the addition amount are listed in Table 9) | |

was polymerized and evaluated in the same manner as described in Examples 1 - 3.

Table 9 shows the kind and amount of the photoinitiator, as well as the results of measurement of the foregoing "thickness".

Table 9

| | Photoinitiator | Addition amount (%) (based on monomer) | Thickness measured (mm) |
|---|---|---|---|
| Example 36 | diphenyl disulfide + camphorquinone | 3.0 / 0.05 | 13.0 |
| Example 37 | dibenzyl disulfide + camphorquinone | 3.0 / 0.05 | 11.1 |
| Example 38 | di-t-butyl disulfide + camphorquinone | 3.0 / 0.05 | 12.5 |
| Example 39 | trimethylene disulfide + camphorquinone | 3.0 / 0.05 | 10.6 |
| Example 40 | p-(phenyl disulfanil) benzoid acid + camphorquinone | 3.0 / 0.05 | 12.0 |
| Example 41 | diphenyl trisulfide + camphorquinone | 3.0 / 0.05 | 10.9 |
| Example 42 | dibenzyl trisulfide + camphorquinone | 3.0 / 0.05 | 12.8 |

As apparent from Table 9, the compositions according to this invention have an excellent photocuring performance also in the case where the filler is added. Furthermore, the photocuring polymerizate according to this invention suffered no substantial discoloration, and were remarkably fine.

Examples 43 - 45

A monomer filler mixture (paste) comprising:

Bis-GMA ... 0.8 g
3G ... 1.2 g
Silane-modified quartz powder ... 8 g
Photopolymerization initiator
(diphenyl disulfide ... 3.0% by weight
camphorquinone ... 0.05% by weight
each based on the monomer)
Storage stabilizer
(Compounds and the addition amount are listed in Table 10)

was polymerized and evaluated in the same manner as described in Example 4 - 6.

Table 10 shows the kind and amount of the photoinitiator as well as the results of the measurement of the aforementioned "thickness" and storage stability.

Table 10

| | Kind of storage stabilizer | Addition amount (%, based on monomer) | Thickness measured (mm) | Storage stability | |
|---|---|---|---|---|---|
| | | | | days of curing 60°C in the dark room | curing time at ambient temp. under circumstantial light |
| Example 43 | 2,4-bis-(n-octylthio)-6-(4-hydroxy-3,5-di-tert-butylanilino)-1,3,5-triazine | 0.1 | 12.2 | more than 14 days | 10 hrs |
| Example 44 | 2-(5-methyl-2-hydroxyphenyl)benzotriazole | 0.1 | 12.2 | more than 14 days | 10 hrs |
| Example 45 | Tetraethylthiuram disulfide | 0.1 | 12.1 | more than 14 days | 10 hrs |

As apparent from Table 10, it can be seen that the composition according to this invention exhibits an excellent photocuring performance even if the filler is added and has an excellent storage stability. Further, the photocuring polymerizate according to this invention was substantially free from discoloration and extremely fine and uniform in appearance.

Examples 46 - 55

A monomer filler mixture (paste) comprising:

| | |
|---|---|
| Bis-GMA | ... 0.8 g |
| 3G | ... 1.2 g |
| Silane modified quartz powder | ... 8 g |
| Photopolymerization initiator (Compounds and the addition amount listed in Table 11) | |

was polymerized and evaluated in the same manner as described in Example 1 - 3.

Table 11 shows the kind and amount of the photoinitiator, as well as the results of the measurement of the foregoing "thickness".

Table 11

| | Photoinitiator | Addition amount (%) (based on monomer) | Thickness measured (mm) |
|---|---|---|---|
| Example 46 | Trioleyl thiophosphate + Camphorquinone | 3.0<br>0.05 | 12.0 |
| Example 47 | Tris(2,3-dichloropropyl) thiophosphate + Camphorquinone | 3.0<br>0.05 | 11.0 |
| Example 48 | O,O'-diethylthiophosphoryl chloride + Camphorquinone | 3.0<br>0.05 | 12.5 |
| Example 49 | O,O'-diisopropylthiol phosphate + Camphorquinone | 3.0<br>0.05 | 10.6 |
| Example 50 | Sodium diamylmonothiophosphate + Camphorquinone | 3.0<br>0.05 | 12.8 |
| Example 51 | O,O'-diethyl dithiophosphate + Camphorquinone | 3.0<br>0.05 | 13.0 |
| Example 52 | Sodium dipropyldithiophosphate + Camphorquinone | 3.0<br>0.05 | 13.0 |
| Example 53 | Zinc dipropyldithiophosphate + Camphorquinone | 3.0<br>0.05 | 10.7 |
| Example 54 | O,O'-di-n-butyl-s-ethyldithiophosphate + Camphorquinone | 3.0<br>0.05 | 11.6 |
| Example 55 | O,O'-dimethyl-dithiophosphoryl acetate + Camphorquinone | 3.0<br>0.05 | 12.8 |

As apparent from Table 11, it can be seen that the composition according to this invention exhibits an excellent photocuring performance even if the filler is added and has an excellent storage stability. Further, the photocuring polymerizate according to this invention was substantially free discoloration and extremely fine and uniform in appearance.

Examples 56 - 58

A monomer-filler mixture (paste) comprising:

Bis-GMA ... 0.8 g
3G ... 1.2 g
Silane-modified quartz powder ... 8 g
Photopolymerization initiator
(O,O'-diethyldithiophosphate ... 3.0% by weight
camphorquinone ... 0.05% by weight
each based on the monomer)
Storage stabilizer
(Compounds and the addition amount are listed in Table 12)

was polymerized and evaluated in the same manner as described in Example 4 - 6.

Table 12 shows the kind and amount of the photoinitiator, as well as the results of the measurement of the aforementioned "thickness" and storage stability.

Table 12

| | Kind of storage stabilizer | Addition amount (%, based on monomer) | Thickness measured (mm) | Storage stability | |
|---|---|---|---|---|---|
| | | | | days of curing 60°C in the dark room | curing time at ambient temp. under circumstantial light |
| Example 56 | 2,4-bis-(n-octylthio)-6-(4-hydroxy-3,5-di-tert-butylanilino)-1,3,5-triazine | 0.1 | 12.2 | more than 14 days | 10 hrs |
| Example 57 | 2-(5-methyl-2-hydroxy-phenyl)benzotriazole | 0.1 | 12.2 | more than 14 days | 10 hrs |
| Example 58 | Tetraethylthiuram di-sulfide | 0.1 | 12.1 | more than 14 days | 10 hrs |

As apparent from Table 12, it can be seen that the composition according to this invention exhibits an excellent photocuring performance even if the filler is added and has an excellent storage stability. Further, the photocuring polymerizate according to this invention was substantially free from discoloration and extremely fine and uniform in appearance.

Comparative Example 5

After pouring each of the compositions corresponding to Examples 1 to 58 respectively into the above-mentioned Teflon tube, the upper surface of the Teflon tube was covered with an aluminum foil so that visible rays could not reach the poured mixture. Then, the tube was disposed such that the upper surface of the poured mixture was at a distance of 1 mm from the light irradiation surface and visible rays were irradiated for 3 minutes. No polymerization took place.

Comparative Example 6

After pouring each of the compositions corresponding to Examples 1 to 58 respectively into the above-mentioned Teflon tube, the upper surface of Teflon tube was covered with an aluminum foil so that visible rays could not reach the poured mixture. Then, the tube was heated for 3 minutes at 60°C. No polymerization took place.

Example 59 - 61, comparative Example 7 - 9

A monomer filler mixture (paste) comprising:

| | |
|---|---|
| Bis-GMA | ... 0.8 g |
| 3G | ... 1.2 g |
| Silane modified quartz powder | ... 7.4 g |
| Silicon dioxide fine powder | ... 0.6 g |
| Photopolymerization initiator (Compound and the addition amount listed in Table 13) | |

was irradiated with visible rays for 60 seconds under the same procedures as those in Examples 1 - 3. Then, the thus obtained photopolymerization curing products were cut into cylindrical specimens each 4 x 6 mm, for which measurement was made of the compression strength, color change after an exposure test to sunlight for one week, and color change after one week immersion test in water at 60°C.

Table 13 shows the kind and amount of the photoinitiator, as well as the results of the above-mentioned measurement.

Table 13

| | Photoinitiator | Addition amount (%) (based on monomer) | Compression strength $(kg/cm^2)$ | Color change after one week exposure to sunlight | Color change after one week immersion in water at 60°C |
|---|---|---|---|---|---|
| Example 59 | thiosalicyclic acid + camphorquinone | 3.0<br>0.05 | 2950 | none | none |
| Example 60 | m-mercaptobenzoic acid + camphorquinone | 3.0<br>0.05 | 2750 | " | " |
| Example 61 | p-mercaptobenzoic acid + camphorquinone | 3.0<br>0.05 | 2800 | " | " |
| Comparative Example 7 | camphorquinone | 3.0 | 1460 | extremely great | extremely great |
| Comparative Example 8 | N,N'-dimethylaniline + camphorquinone | 3.0<br>0.05 | 1780 | " | " |
| Comparative Example 9 | 5-butylbarbituric acid + camphorquinone | 3.0<br>0.05 | 1800 | great | great |

As apparent from Table 13, the compositions according to this invention have an excellent mechanical strength and extremely high color stability as compared with the known compositions Of the comparative examples.

Examples 62 - 70 and comparative Example 10

A monomer-filler mixture (paste) comprising:

| | |
|---|---|
| Bis-GMA | ... 0.8 g |
| 3G | ... 1.2 g |
| Silane-modified quartz powder | ... 7.4 g |
| Fine silicon dioxide powder | ... 0.6 g |

Photopolymerization initiator

(thiosalicyclic acid ... 3.0% by weight

camphorquinone ... 0.05% by weight

each based on the monomer)

(Compounds and the addition amount are listed in Table 14)

was polymerized and evaluated in the same manner of Examples 59 - 61.

Table 14 shows the kind and amount of the photoinitiator, as well as the results of the above-mentioned measurement.

Table 14

| | Kind of storage stabilizer | Compression strength ($kg/cm^2$) | Change in the color | |
|---|---|---|---|---|
| | | | after one week exposure for sunlight | after one week immersion in water at 60°C |
| Example 62 | 2,4-bis(n-octylthio)-6-(4-hydroxy-3,5-di-tert-butylanilino)-1,3,5-triazine | 3100 | none | none |
| Example 63 | 2-(N,N-dibutylamino)-4,6-dimercapto-1,3,5-triazine | 3090 | none | none |
| Example 64 | 2-anilino-4,6-dimercapto-1,3,5-triazine | 3090 | none | none |
| Example 65 | 2-(5-methyl-2-hydroxyphenyl)benzotriazole | 3110 | none | none |
| Example 66 | 2-ethoxy-2'-ethyloxalic acid bisanilide | 3090 | none | none |
| Example 67 | 2-(3,5-di-tert-butyl-4-hydroxybenzyl)-2-n-butyl malonic acid bis(1,2,2,6,6-pentamethyl-4-piperidyl) | 3100 | none | none |
| Example 68 | Tetraethylthiuram disulfide | 3100 | none | none |
| Example 69 | Tetramethylthiuram disulfide | 3090 | none | none |
| Example 70 | Tetrakis(2-ethylhexyl)thiuram disulfide | 3090 | none | none |
| Comparative Example 10 | Hydroquinone | 2250 | none | none |

As apparent from Table 14, the compositions according to this invention have an excellent mechanical strength and extremely high color stability, even if the storage stabilizer is added as compared with the known compositions of the comparative example.

Examples 72 - 78

A monomer filler mixture (paste) comprising:

| | |
|---|---|
| Bis-GMA | ... 0.8 g |
| 3G | ... 1.2 g |
| Silane modified quartz powder | ... 7.4 g |
| Silicon dioxide fine powder | ... 0.6 g |
| Photopolymerization initiator (Compound and the addition amount listed in Table 15) | |

was polymerized and evaluated in the same manner described in Examples 59 - 61.

Table 15 shows the kind and amount of the photoinitiator, as well as the results of the above-mentioned measurement.

Table 15

| | Photoinitiator | Addition amount (%) (based on monomer) | Compression strength ($kg/cm^2$) | Color change after one week exposure to sunlight | Color change after one week immersion in water at 60°C |
|---|---|---|---|---|---|
| Example 72 | diphenyl disulfide + camphorquinone | 3.0<br>0.05 | 2980 | none | none |
| Example 73 | dibenzyl disulfide + camphorquinone | 3.0<br>0.05 | 2770 | " | " |
| Example 74 | di-t-butyl disulfide + camphorquinone | 3.0<br>0.05 | 2800 | " | " |
| Example 75 | trimethylene disulfide + camphorquinone | 3.0<br>0.05 | 2660 | none | none |
| Example 76 | p-(phenyl disulfanil) benzoic acid + camphorquinone | 3.0<br>0.05 | 2790 | " | " |
| Example 77 | diphenyl trisulfide + camphorquinone | 3.0<br>0.05 | 2620 | none | none |
| Example 78 | dibenzyl trisulfide + camphorquinone | 3.0<br>0.05 | 2600 | " | " |

As apparent from Table 15, the compositions according to this invention have an excellent mechanical strength and extremely high color stability.

Examples 79 - 88 and Comparative Example 11

A monomer-filler mixture (paste] comprising:

| | |
|---|---|
| Bis-GMA | ... 0.8 g |
| 3G | ... 1.2 g |
| Silane-modified quartz powder | ... 7.4 g |
| Fine silicon dioxide powder | ... 0.6 g |

Photopolymerization initiator

(diphenyl disulfide ... 3.0% by weight

camphorquinone ... 0.05% by weight

each based on the monomer)

was polymerized and evaluated in the same manner as described in Examples 59 - 61.

Table 16 shows the kind and amount of the storage stabilizer and the results of the measurement as described above.

Table 16

| | Kind of storage stabilizer | Compression strength ($kg/cm^2$) | Change in the color | |
|---|---|---|---|---|
| | | | after one week exposure for sunlight | after one week immersion in water at 60°C |
| Example 79 | 2,4-bis(n-octylthio)-6-(4-hydroxy-3,5-di-tert-butylanilino)-1,3,5-triazine | 2950 | none | none |
| Example 80 | 2-(N,N-dibutylamino)-4,6-dimercapto-1,3,5-triazine | 2940 | none | none |
| Example 81 | 2-anilino-4,6-dimercapto-1,3,5-triazine | 2940 | none | none |
| Example 82 | 2-(5-methyl-2-hydroxyphenyl)benzotriazole | 2960 | none | none |
| Example 83 | 2-ethoxy-2'-ethyloxalic acid bisanilide | 2940 | none | none |
| Example 84 | 2-(3,5-di-tert-butyl-4-hydroxybenzyl)-2-n-butyl malonic acid bis(1,2,2,6,6-pentamethyl-4-piperidyl) | 2950 | none | none |
| Example 85 | Tetraethylthiuram disulfide | 2950 | none | none |
| Example 86 | Tetramethylthiuram disulfide | 2940 | none | none |
| Example 87 | Tetrakis(2-ethylhexyl)thiuram disulfide | 2940 | none | none |
| Comparative Example 11 | Hydroquinone | 2100 | none | none |

As apparent from Table 16, the compositions according to this invention have an excellent mechanical strength and extremely high color stability, even if the storage stabilizer is added as compared with the known compositions of the comparative example.

Examples 89 - 98

A monomer filler mixture (paste) comprising:

| | |
|---|---|
| Bis-GMA | ... 0.8 g |
| 3G | ... 1.2 g |
| Silane modified quartz powder | ... 7.4 g |
| Silicon dioxide fine powder | ... 0.6 g |
| Photopolymerization initiator (Compound and the addition amount listed in Table 17) | |

was polymerized and evaluated in the same manner described in Examples 59 - 61.

Table 17 shows the kind and amount of the photoinitiator, as well as the results of the above-mentioned measurement.

Table 17

| | Photopolymerization Initiator | Amount (%) (to monomer) | Compression resistance ($kg/cm^2$) | Change in color: after one week exposure to sunlight | Change in color: after one week immersion in water at 60°C |
|---|---|---|---|---|---|
| Example 89 | Trioleyl thiophosphate + Camphorquinone | 3.0 / 0.05 | 2990 | none | none |
| Example 90 | Tris(2,3-dichloropropyl) thiophosphate + Camphorquinone | 3.0 / 0.05 | 2720 | " | " |
| Example 91 | O,O'-diethylthiophosphoryl chloride + Camphorquinone | 3.0 / 0.05 | 2640 | " | " |
| Example 92 | O,O'-diisopropylthiol phosphate + Camphorquinone | 3.0 / 0.05 | 2800 | none | none |
| Example 93 | Sodium diamylmonothio-phosphate + Camphorquinone | 3.0 / 0.05 | 2950 | " | " |

Table 17 (Continued)

| | Photopolymerization Initiator | Amount (%) (to monomer) | Compression resistance ($kg/cm^2$) | Change in color | |
|---|---|---|---|---|---|
| | | | | after one week exposure to sunlight | after one week immersion in water at 60°C |
| Example 94 | O,O'-diethyl dithiophosphate<br>+<br>Camphorquinone | 3.0<br><br>0.05 | 3000 | none | none |
| Example 95 | Sodium dipropyldithiophosphate<br>+<br>Camphorquinone | 3.0<br><br>0.05 | 2980 | none | none |
| Example 96 | Zinc dipropyldithiophosphate<br>+<br>Camphorquinone | 3.0<br><br>0.05 | 2770 | " | " |
| Example 97 | O,O'-di-n-butyl-s-ethyldithiophosphate<br>+<br>Camphorquinone | 3.0<br><br>0.05 | 2830 | " | " |
| Example 98 | O,O'-dimethyl-dithiophosphoryl acetate<br>+<br>Camphorquinone | 3.0<br><br>0.05 | 2900 | " | " |

As apparent from Table 17, the compositions according to this invention have an excellent mechanical strength and extremely high color stability.

Examples 99 - 108 and Comparative Example 12

A monomer filler mixture (paste) comprising:

| | |
|---|---|
| Bis-GMA | ... 0.8 g |
| 3G | ... 1.2 g |
| Silane modified quartz powder | ... 7.4 g |
| Silicon dioxide fine powder | ... 0.6 g |
| Photopolymerization initiator | |
| (O,O'-diethyldithiophosphate | ... 3.0% by weight |
| camphorquinone | ... 0.05% by weight |
| each based on the monomer) | |

was polymerized and evaluated in the same manner described in Examples 59 - 61.

Table 18 shows the kind and amount of the storage stabilizer, as well as the results of the above-mentioned measurement.

Table 18

| | Kind of storage stabilizer | Compression strength ($kg/cm^2$) | Change in the color | |
|---|---|---|---|---|
| | | | after one week exposure for sunlight | after one week immersion in water at 60°C |
| Example 99 | 2,4-bis(n-octylthio)-6-(4-hydroxy-3,5-di-tert-butylanilino)-1,3,5-triazine | 2920 | none | none |
| Example 100 | 2-(N,N-dibutylamino)-4,6-dimercapto-1,3,5-triazine | 2910 | none | none |
| Example 101 | 2-anilino-4,6-dimercapto-1,3,5-triazine | 2910 | none | none |
| Example 102 | 2-(5-methyl-2-hydroxyphenyl)benzotriazole | 2930 | none | none |
| Example 103 | 2-ethoxy-2'-ethyloxalic acid bisanilide | 2910 | none | none |
| Example 104 | 2-(3,5-di-tert-butyl-4-hydroxybenzyl)-2-n-butyl malonic acid bis(1,2,2,6,6-pentamethyl-4-piperidyl) | 2920 | none | none |
| Example 105 | Tetraethylthiuram disulfide | 2920 | none | none |
| Example 106 | Tetramethylthiuram disulfide | 2910 | none | none |
| Example 107 | Tetrakis(2-ethylhexyl)thiuram disulfide | 2910 | none | none |
| Comparative Example 12 | Hydroquinone | 2070 | none | none |

As apparent from Table 18, the compositions according to this invention have an excellent mechanical strength and extremely high color stability, even if the storage stabilizer is added as compared with the known compositions of the comparative examples.

## Claims

1. A photopolymerizable composition comprising a vinyl monomer and a photopolymerization initiator, said vinyl monomer being selected from styrene, acrylonitrile, vinyl acetate, methyl acrylate, methyl methacrylate, ethyl acrylate, ethyl methacrylate, butyl acrylate, butyl methacrylate, hydroxyethyl acrylate, hydroxyethyl methacrylate, methoxyethyl acrylate, methoxyethyl methacrylate, glycidyl acrylate, glycidyl methacrylate, ethylene glycol di-acrylate, ethylene glycol di-methacrylate, diethylene glycol di-acrylate, diethylene glycol di-methacrylate, triethylene glycol di-acrylate, triethylene glycol di-methacrylate, polyethylene glycol di-acrylate, polyethylene glycol di-methacrylate, 1,4-butane-diol di-acrylate, 1,4-butane-diol di-methacrylate, 1,3-butane-diol di-acrylate, 1,3-butane-diol di-methacrylate, 1,6-hexane-diol di-acrylate, 1,6-butane-diol di-methacrylate, glycerin di-acrylate or di-methacrylate of the following general formula:

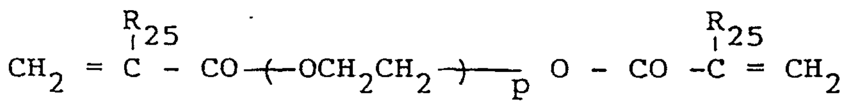

where $R_{25}$ represents a hydrogen atom or methyl group and p is an integer from 1 to 20, bisphenol A diglycidyl acrylates, bisphenol A diglycidyl methacrylates, urethane di-acrylates, urethane di-methacrylates, trimethylolpropane tri-acrylate, trimethyl-olpropane tri-methacrylate, pentaerythritol tetra-acrylate, penta-erythrytol tetra-methacrylate, bis-phenol A di-acrylate or di-methacrylate represented by the following general formula:

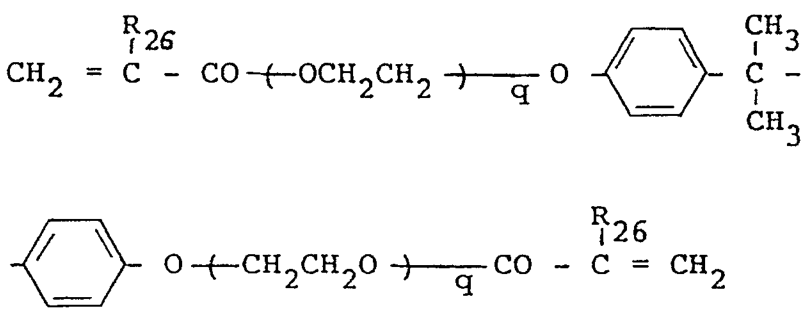

where $R_{26}$ represents a hydrogen atom or methyl group and q is an integer from 1 to 20, wherein said photopolymerization initiator is a combination of (a) at least one compound selected from a mercaptocarboxylic acid, a polysulfide and a thiophosphoric derivative with (b) camphorquinone.

2. The photopolymerizable composition according to claim 1, which further comprises a storage stabilizer.

3. The photopolymerizable composition according to claim 1, which further comprises a filler.

4. The photopolymerizable composition according to any of claims 1 to 3 wherein the mercaptocarboxylic acid is a compound represented by the following general formulas (I) or (II):

(I)

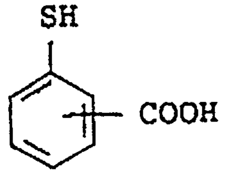

or

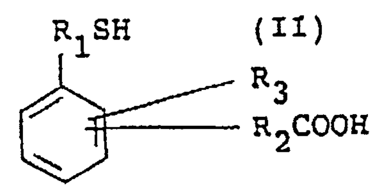

(II)

independently an alkylene group having 1 to 5 carbon atoms or a phenylene group and $R_3$ represents a nitro group, a hydroxy group, an amino group or a halogen atom.

5. The photopolymerizable composition according to any of claims 1 to 3, wherein said polysulfide is a

compound represented by the following formula:

$$R_4 - S -( S )_m- S - R_4$$

where:

m is an integer of from 0 to 10;

$R_4$ is an unsaturated or saturated alkyl group having 1 to 20 carbon atoms, a phenyl or a benzyl group, each of which may be either unsubstituted or substituted with a carboxylic acid group at any position.

6. The photopolymerizable composition according to any of Claims 1 to 3, wherein said thiophosphoric derivative is selected from the group consisting of:

a monothiophosphoric compound represented by the general formula:

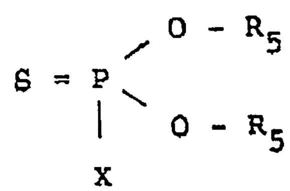

wherein $R_5$ represents a hydrogen atom, an alkali metal or an alkyl group having 1 to 20 carbon atoms and X represents a halogen atom,

a dithiophosphoric diester represented by the general formula:

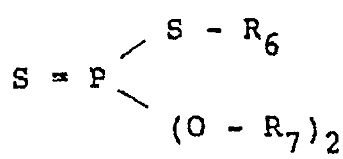

wherein $R_6$ represents a hydrogen atom, an alkali metal, a copper atom or a zinc atom and $R_7$ represents an alkyl group having 1 to 20 carbon atoms, and

a thiophosphoric triester represented by the general formula:

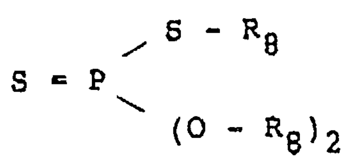

wherein $R_8$ represents an alkyl group having 1 to 20 carbon atoms.

7. The photopolymerizable composition according to Claim 2 or 3, wherein the storage stabilizer is at least one compound selected from triazine compounds, benzotriazole compounds, oxalic acid anilide compounds, hindered amine compounds, and thiuram sulfide compounds.

8. The photopolymerizable composition according to Claim 4, wherein the mercaptocarboxylic acid is at least one mercaptobenzoic acid selected from ortho-mercaptobenzoic acid (i.e., thiosalicyclic acid), metha-mercaptobenzoic acid, and para-mercaptobenzoic acid.

9. The photopolymerizable composition according to Claim 5, wherein said polysulfide is diphenyl

disulfide, dibenzyl disulfide, di-tert-butyl disulfide, trimethylene disulfide, para-(phenyl disulfanil)benzoic acid, diphenyl trisulfide or dibenzyl trisulfide.

**10.** The photopolymerizable composition according to Claim 6, wherein the monothiophosphoric compound is trioleyl thiophosphate, tris(2,3-dichloropropyl) thiophosphate, 0,0'-diethylthiophosphoryl chloride, 0,0'-diisopropyl thiophosphate or sodium diamylmonothiophosphate; the dithiophosphoric diester is 0,0'-diethyl dithiophosphate, sodium dipropyldithiophosphate, zinc dipropyldithiophosphate or copper 0,0'-di(2-ethylhexyl)-dithiophosphate; and the dithiophosphoric triester is 0,0'-di-n-butyl-s-ethyldithiophosphate or 0,0'-dimethyl-dithiophosphoryl-acetate.

**11.** The photopolymerizable composition according to Claim 7, wherein the triazine compounds are represented by the general formula:

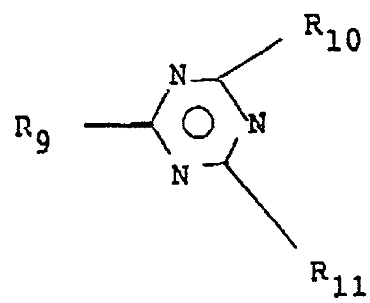

wherein $R_9$ , $R_{10}$ and $R_{11}$ independently represent a hydrogen atom, a halogen atom, an alkyl group having 1 to 20 carbon atoms, a hydroxy group, alkoxy group having 1 to 20 carbon atoms, a phenoxy group, an alkyl peroxy group having 1 to 20 carbon atoms, an amino group represented by $NR_{12}R_{13}$ (in which $R_{12}$ and $R_{13}$ independently represent a hydrogen atom, an alkyl group having 1 to 20 carbon atoms or an aromatic group having 6 to 20 carbon atoms or derivatives thereof), or a thio group represented by $SR_{14}$ in which $R_{14}$ represents hydrogen atom or alkyl group.

**12.** The photopolymerizable composition according to Claim 11, wherein the triazine compounds are selected from 2,4-bis-(n-octylthio)-6-(4-hydroxy-3,5-di-tert-butylanilino)-1,3,5-triazine, 2-(N,N-dibutylamino)-4,6-dimercapto-1,3,5-triazine, and 2-anilino-4,6-dimercapto-1,3,5-triazine.

**13.** The photopolymerizable composition according to Claim 7, wherein the benzotriazole compounds are represented by the general formula:

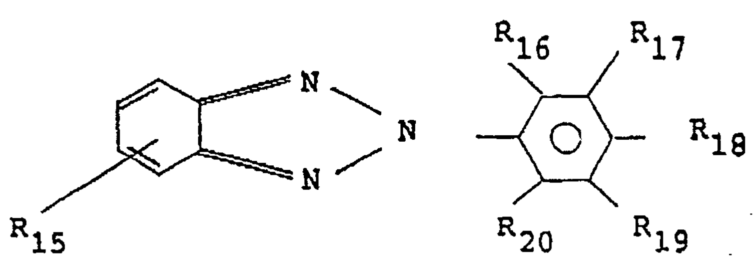

wherein $R_{15}$ represents a hydrogen atom or a halogen atom and $R_{16}$ , $R_{17}$ , $R_{18}$ , $R_{19}$ and $R_{20}$ independently represent a hydrogen atom, a hydroxy group, an alkyl group having 1 to 10 carbon atoms, a benzyl group or derivatives thereof.

**14.** The photopolymerizable composition according to Claim 13, wherein the benzotriazole compound is at least one compound selected from 2-(5-methyl-2-hydroxyphenyl)benzotriazole, 2-(2-hydroxy-3,5-bis-(α,α-dimethylbenzyl)phenyl) benzotriazole, 2-(3,5-di-tert-butyl-2-hydroxyphenyl)benzotriazole, 2-(3-tert-butyl-5-methyl-2-hydroxyphenyl)-5-chlorobenzotriazole, 2-(3,5-di-tert-butyl-2-hydroxyphenyl)-5-chlorobenzotriazole, and 2-(3,5-di-tert-amyl-2-hydroxyphenyl)benzotriazole.

**15.** The photopolymerizable composition according to Claim 7, wherein the oxalic acid anilide compound is 2-ethoxy-2'-ethyloxalic acid anilide or 2-ethoxy-5-tert-butyl-2'-ethyloxalic acid bisanilide.

**16.** The photopolymerizable composition according to Claim 7, wherein the hindered amine compound is a polycondensate of dimethyl-1-(2-hydroxyethyl)-4-hydroxy-2,6,6,6-tetramethylpiperidine succinate, poly-(6-(1,1,3,3-tetramethylbutyl)imino-1,3,5-triazine-2,4-di-yl),(2,2,6,6,-tetramethyl-4-piperidyl)imino hexamethylene (2,2,6,6-tetramethyl-4-piperidyl)imino) or 2-(3,5-di-tert-butyl-4-hydroxybenzyl)-2-n-butyl malonic acid bis(1,2,2,6,6-pentamethyl-4-piperidyl).

**17.** The photopolymerizable composition according to Claim 7, wherein the thiuram sulfide compound is represented by the general formula:

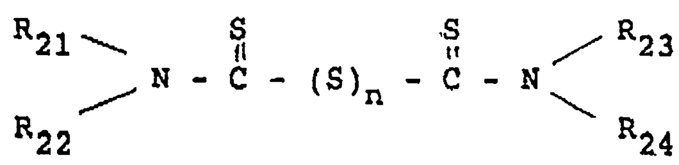

$R_{21}$ , $R_{22}$ , $R_{23}$ and $R_{24}$ independently represent a hydrogen atom or an alkyl group having 1 to 10 carbon atoms and n is an integer from 1 to 4.

**18.** The photopolymerizable composition according to Claim 17, wherein the thiuram sulfide compound is at least one compound selected from tetraethylthiuram disulfide, tetramethylthiuram disulfide, and tetrakis (2-ethylhexyl)thiuram disulfide.--

**Revendications**

**1.** Une composition photopolymérisable comprenant un monomère vinylique et un initiateur de photopolymérisation, ledit monomère vinylique étant choisi parmi le styrène, l'acrylonitrile, l'acétate de vinyle, l'acrylate de méthyle, le méthacrylate de méthyle, l'acrylate d'éthyle, le méthacrylate d'éthyle, l'acrylate de butyle, le méthacrylate de butyle, l'acrylate d'hydroxyéthyle, le méthacrylate d'hydroxyéthyle, l'acrylate de méthoxyéthyle, le méthacrylate de méthoxyéthyle, l'acrylate de glycidyle, le méthacrylate de glycidyle, le diacrylate d'éthylène-glycol, le diméthacrylate d'éthylène-glycol, le diacrylate de diéthylène-glycol, le diméthacrylate de diéthylène-glycol, le diacrylate de triéthylène-glycol, le diméthacrylate de triéthylène-glycol, un diacrylate de polyéthylène-glycol, un diméthacrylate de polyéthylène-glycol, le diacrylate de 1,4-butanediol, le diméthacrylate de 1,4-butanediol, le diacrylate de 1,3-butanediol, le diméthacrylate de 1,3-butanediol, le diacrylate de 1,6-hexanediol, le diméthacrylate de 1,6-butanediol, un diacrylate ou diméthacrylate de glycérol de la formule générale suivante :

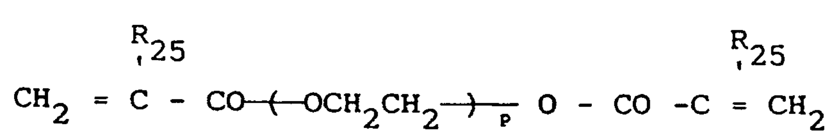

où $R_{25}$ représente un atome d'hydrogène ou un groupe méthyle et p est un nombre entier de 1 à 20, les acrylates diglycidyliques de bisphénol A, les méthacrylates diglycidyliques de bisphénol A, les diacrylates d'uréthannes, les diméthacrylates d'uréthannes, le triacrylate de triméthylolpropane, le triméthacrylate de triméthylolpropane, le tétra-acrylate de pentaérythritol, le tétraméthacrylate de pentaérythritol, un diacrylate ou diméthacrylate de bisphénol A représenté par la formule générale suivante :

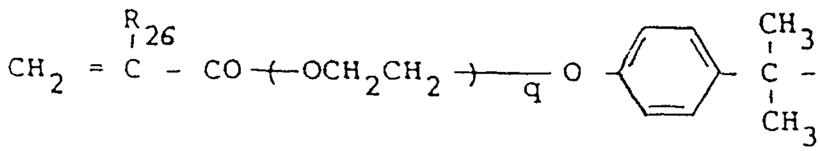

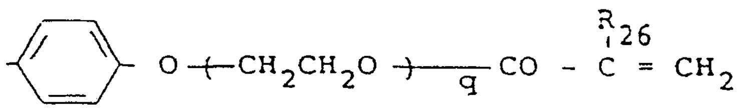

où $R_{26}$ représente un atome d'hydrogène ou un groupe méthyle et q est un nombre entier de 1 à 20, dans laquelle ledit initiateur de photopolymérisation est une combinaison de (a) au moins un composé choisi parmi un acide mercaptocarboxylique, un polysulfure et un dérivé thiophosphorique avec (b) la camphoquinone.

2. La composition photopolymérisable selon la revendication 1, qui comprend de plus un stabilisant de stockage.

3. La composition photopolymérisable selon la revendication 1, qui comprend de plus une charge.

4. La composition photopolymérisable selon l'une quelconque des revendications 1 à 3, dans laquelle l'acide mercaptocarboxylique est un composé représenté par l'une des formules générales (I) et (II) suivantes :

(I) 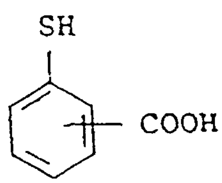

ou

(II) 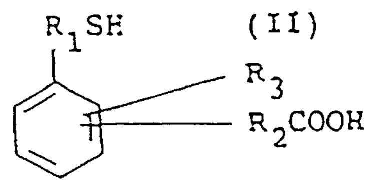

indépendamment un groupe alkylène ayant 1 à 5 atomes de carbone ou un groupe phénylène et $R_3$ représente un groupe nitro, un groupe hydroxyle, un groupe amino ou un atome d'halogène.

5. La composition photopolymérisable selon l'une quelconque des revendications 1 à 3, dans laquelle ledit polysulfure est un composé représenté par la formule suivante :

$R_4 - S - (S)_m - S - R_4$

où :

m est un nombre entier de 0 à 10 ;

$R_4$ est un groupe alkyle saturé ou insaturé ayant 1 à 20 atomes de carbone, un groupe phényle ou un groupe benzyle, dont chacun peut être non substitué ou être substitué par un groupe acide carboxylique à n'importe quelle position.

6. La composition photopolymérisable selon l'une quelconque des revendications 1 à 3, dans laquelle ledit dérivé thiophosphorique est choisi dans le groupe formé par :

un composé monothiophosphorique représenté par la formule générale :

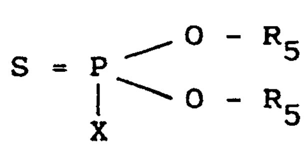

où $R_5$ représente un atome d'hydrogène, un métal alcalin ou un groupe alkyle ayant 1 à 20 atomes de carbone et X représente un atome d'halogène,

un diester dithiophosphorique représenté par la formule générale :

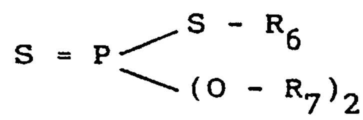

où $R_6$ représente un atome d'hydrogène, un métal alcalin, un atome de cuivre ou un atome de zinc et $R_7$ représente un groupe alkyle ayant 1 à 20 atomes de carbone, et

un triester thiophosphorique représenté par la formule générale :

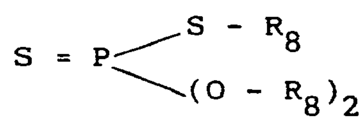

où $R_8$ représente un groupe alkyle ayant 1 à 20 atomes de carbone.

**7.** La composition photopolymérisable selon la revendication 2 ou 3, dans laquelle le stabilisant de stockage consiste en au moins un composé choisi parmi des dérivés de triazine, des dérivés de benzotriazole, des dérivés d'anilide d'acide oxalique, des amines à empêchement stérique et des dérivés de sulfure de thiurame.

**8.** La composition photopolymérisable selon la revendication 4, dans laquelle l'acide mercaptocarboxylique consiste en au moins un acide mercaptobenzoïque choisi parmi l'acide ortho-mercaptobenzoïque (c'est-à-dire l'acide thiosalicylique), l'acide méta-mercaptobenzoïque et l'acide para-mercaptobenzoïque.

**9.** La composition photopolymérisable selon la revendication 5, dans laquelle ledit polysulfure est le bisulfure de diphényle, le bisulfure de dibenzyle, le bisulfure de di-tert.-butyle, le bisulfure de triméthylène, l'acide para-(phényl-disulfanil)benzoïque, le trisulfure de diphényle ou le trisulfure de dibenzyle.

**10.** La composition photopolymérisable selon la revendication 6, dans laquelle le composé monothiophosphorique est le thiophosphate de trioléyle, le thiophosphate de tris(2,3-dichloropropyle), le chlorure de O,O'-diéthylthiophosphoryle, le thiophosphate de O,O'-diisopropyle ou le monothiophosphate de diamyle et de sodium ; le diester dithiophosphorique est un dithiophosphate de O,O'-diéthyle, le dithiophosphate de dipropyle et de sodium, le dithiophosphate de dipropyle et de zinc ou le dithiophosphate de O,O'-di(2-éthylhexyle) et de cuivre ; et le triester dithiophosphorique est le dithiophosphate de O,O'-di-n-butyle et de S-éthyle ou un O,O'-diméthyl-dithiophosphorylacétate.

**11.** La composition photopolymérisable selon la revendication 7, dans laquelle les dérivés de triazine sont représentés par la formule générale :

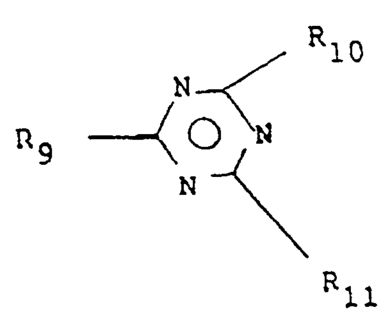

où $R_9$, $R_{10}$ et $R_{11}$ représentent indépendamment un atome d'hydrogène, un atome d'halogène, un groupe alkyle ayant 1 à 20 atomes de carbone, un groupe hydroxyle, un groupe alcoxy ayant 1 à 20 atomes de carbone, un groupe phénoxy, un groupe alkylperoxy ayant 1 à 20 atomes de carbone, un groupe amino représenté par $NR_{12}R_{13}$ (où $R_{12}$ et $R_{13}$ représentent indépendamment un atome d'hydrogène, un groupe alkyle ayant 1 à 20 atomes de carbone ou un groupe aromatique ayant 6 à 20 atomes de carbone ou un de leurs dérivés), ou un groupe thio représenté par $SR_{14}$ où $R_{14}$ représente un atome d'hydrogène ou un groupe alkyle.

**12.** La composition photopolymérisable selon la revendication 11, dans laquelle les dérivés de triazine sont choisis parmi la 2,4-bis(n-octylthio)-6-(4-hydroxy-3,5-di-tert.-butylanilino)1,3,5-triazine, la 2-(N,N-dibutylamino)-4,6-dimercapto-1,3,5-triazine et la 2-anilino-4,6-dimercapto-1,3,5-triazine.

**13.** La composition photopolymérisable selon la revendication 7, dans laquelle les dérivés de benzotriazole sont représentés par la formule générale :

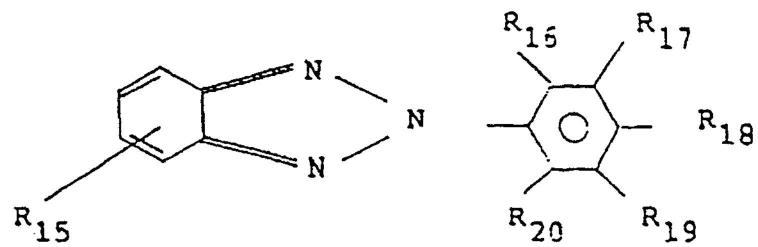

où $R_{15}$ représente un atome d'hydrogène ou un atome d'halogène et $R_{16}$, $R_{17}$, $R_{18}$, $R_{19}$ et $R_{20}$ représentent indépendamment un atome d'hydrogène, un groupe hydroxyle, un groupe alkyle ayant 1 à 10 atomes de carbone, un groupe benzyle ou un de leurs dérivés.

**14.** La composition photopolymérisable selon la revendication 13, dans laquelle le dérivé de benzotriazole consiste en au moins un composé choisi parmi le 2-(5-méthyl-2-hydroxyphényl)benzotriazole, le 2-(2-hydroxy-3,5-bis(α,α-diméthylbenzyl)phényl)benzotriazole, le 2-(3,5-di-tert.-butyl-2-hydroxyphényl)-benzotriazole, le 2-(3-tert.-butyl-5-méthyl-2-hydroxyphényl)-5-chlorobenzotriazole,le 2-(3,5-di-tert.-butyl-2-hydroxyphényl)-5-chlorobenzotriazole et le 2-(3,5-di-tert.-amyl-2-hydroxyphényl)benzotriazole.

**15.** La composition photopolymérisable selon la revendication 7, dans laquelle le dérivé d'anilide d'acide oxalique est l'anilide d'acide 2-éthoxy-2'-éthyloxalique ou le bisanilide d'acide 2-éthoxy-5-tert.-butyl-2'-éthyloxalique.

**16.** La composition photopolymérisable selon la revendication 7, dans laquelle l'amine à empêchement stérique est un polycondensat de 1-(2-hydroxyéthyl)-4-hydroxy-2,6,6,6-tétraméthylpipéridine-succinate de diméthyle, un poly(6-(1,1,3,3-tétraméthylbutyl)imino-1,3,5-triazine-2,4-diyle), la (2,2,6,6-tétraméthyl-4-pipéridyl)imino-hexaméthylène-(2,2,6,6-tétraméthyl-4-pipéridyl)imine) ou l'acide 2-(3,5-di-tert.-butyl-4-hydroxybenzyl)-2-n-butylmalonique bis(1,2,2,6,6-pentaméthyl-4-pipéridyle).

**17.** La composition photopolymérisable selon la revendication 7, dans laquelle le dérivé de sulfure de thiurame est représenté par la formule générale :

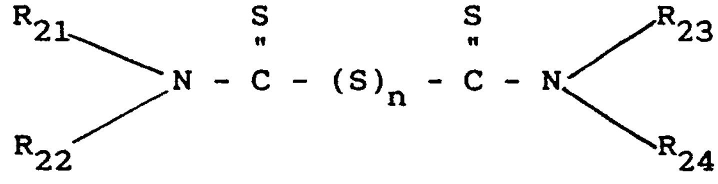

où $R_{21}$, $R_{22}$, $R_{23}$ et $R_{24}$ représentent indépendamment un atome d'hydrogène ou un groupe alkyle ayant 1 à 10 atomes de carbone et n est un nombre entier de 1 à 4.

**18.** La composition photopolymérisable selon la revendication 17, dans laquelle le dérivé de sulfure de thiurame consiste en au moins un composé choisi parmi le bisulfure de tétraéthylthiurame, le bisulfure de tétraméthylthiurame et le bisulfure de tétrakis(2-éthylhexyl)thiurame.

## Patentansprüche

**1.** Photopolymerisierbare Mischung, die ein Vinylmonomer und einen Photopolymerisationsinitiator enthält, wobei das Vinylmonomer aus Styrol, Acrylnitril, Vinylacetat, Methylacrylat, Methylmethacrylat, Ethylacrylat, Ethylmethacrylat, Butylacrylat, Butylmethacrylat, Hydroxyethylacrylat, Hydroxyethylmethacrylat, Methoxyethylacrylat, Methoxyethylmethacrylat, Glycidylacrylat, Glycidylmethacrylat, Ethylenglykoldiacrylat, Ethylenglykoldimethacrylat, Diethylenglykoldiacrylat, Diethylenglykoldimethacrylat, Triethylenglykoldiacrylat, Triethylenglykoldimethacrylat, Polyethylenglykoldiacrylat, Polyethylenglykoldimethacrylat, 1,4-Butandioldiacrylat, 1,4-Butandioldimethacrylat, 1,3-Butandioldiacrylat, 1,3-Butandioldimethacrylat, 1,6-Hexandioldiacrylat, 1,6-Butandioldimethacrylat, Glycerindiacrylat oder -dimethacrylat der folgenden allgemeinen Formel:

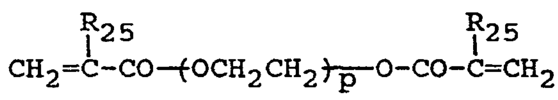

worin $R_{25}$ ein Wasserstoffatom oder eine Methylgruppe ist und p eine ganze Zahl von 1 bis 20 ist, Bisphenol-A-diglycidylacrylaten, Bisphenol-A-diglycidylmethacrylaten, Urethandiacrylaten, Urethandimethacrylaten, Trimethylolpropantriacrylat, Trimethylolpropantrimethacrylat,Pentaerythrittetraacrylat, Pentaerythrittetramethacrylat, Bisphenol-A-diacrylat oder -dimethacrylat, das durch die folgende allgemeine Formel wiedergegeben wird:

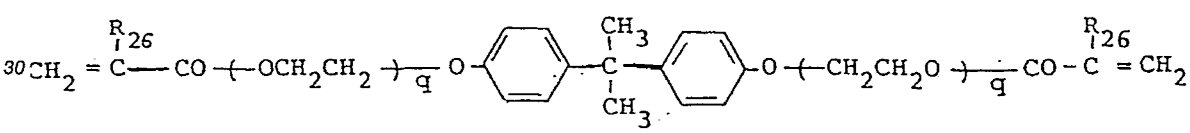

worin $R_{26}$ ein Wasserstoffatom oder eine Methylgruppe ist und q eine ganze Zahl von 1 bis 20 ist, ausgewählt ist, wobei der Photopolymerisationsinitiator eine Kombination von (a) mindestens einer Verbindung, die aus einer Mercaptocarbonsäure, einem Polysulfid und einem Thiophosphorsäurederivat ausgewählt ist, mit (b) Campherchinon ist.

**2.** Photopolymerisierbare Mischung nach Anspruch 1, die ferner ein Mittel zur Verbesserung der Lagerungsbeständigkeit enthält.

**3.** Photopolymerisierbare Mischung nach Anspruch 1, die ferner einen Füllstoff enthält.

**4.** Photopolymerisierbare Mischung nach einem der Ansprüche 1 bis 3, bei der die Mercaptocarbonsäure eine Verbindung ist, die durch die folgende allgemeine Formel (I) oder (II) wiedergegeben wird:

(I)

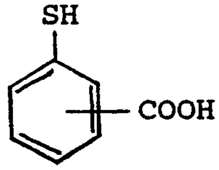

oder

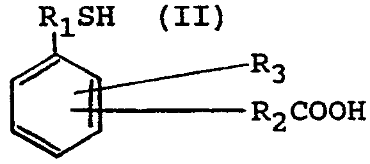

(II)

unabhängig voneinander eine Alkylengruppe mit 1 bis 5 Kohlenstoffatomen oder eine Phenylengruppe ... und $R_3$ eine Nitrogruppe, eine Hydroxylgruppe, eine Aminogruppe oder ein Halogenatom bedeutet.

**5.** Photopolymerisierbare Mischung nach einem der Ansprüche 1 bis 3, bei der das Polysulfid eine

Verbindung ist, die durch die folgende Formel wiedergegeben wird:

$$R_4-S-(S)_m-S-R_4$$

worin m eine ganze Zahl von 0 bis 10 ist und $R_4$ eine ungesättigte oder gesättigte Alkylgruppe mit 1 bis 20 Kohlenstoffatomen, eine Phenyl- oder eine Benzylgruppe ist, von denen jede entweder unsubstituiert oder in irgendeiner Stellung mit einer Carbonsäuregruppe substituiert sein kann.

6. Photopolymerisierbare Mischung nach einem der Ansprüche 1 bis 3, bei der das Thiophosphorsäurederivat aus der Gruppe ausgewählt ist, die aus
einer Monothiophosphorsäureverbindung, die durch die allgemeine Formel:

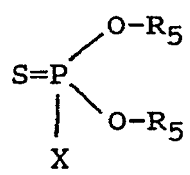

wiedergegeben wird, worin $R_5$ ein Wasserstoffatom, ein Alkalimetall oder eine Alkylgruppe mit 1 bis 20 Kohlenstoffatomen bedeutet und X ein Halogenatom bedeutet, einem Dithiophosphorsäurediester, der durch die allgemeine Formel:

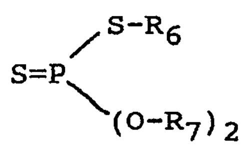

wiedergegeben wird, worin $R_6$ ein Wasserstoffatom, ein Alkalimetall, ein Kupferatom oder ein Zinkatom bedeutet und $R_7$ eine Alkylgruppe mit 1 bis 20 Kohlenstoffatomen bedeutet, und
einem Thiophosphorsäuretriester, der durch die allgemeine Formel:

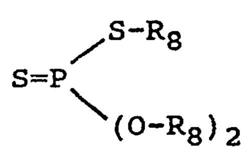

wiedergegeben wird, worin $R_8$ eine Alkylgruppe mit 1 bis 20 Kohlenstoffatomen bedeutet,
besteht.

7. Photopolymerisierbare Mischung nach Anspruch 2 oder 3, bei der das Mittel zur Verbesserung der Lagerungsbeständigkeit mindestens eine Verbindung ist, die aus Triazinverbindungen, Benzotriazolverbindungen, Oxalsäureanilidverbindungen, sterisch gehinderten Aminverbindungen und Thiuramsulfidverbindungen ausgewählt ist.

8. Photopolymerisierbare Mischung nach Anspruch 4, bei der die Mercaptocarbonsäure mindestens eine Mercaptobenzoesäure ist, die aus ortho-Mercaptobenzoesäure (d.h., Thiosalicylsäure), meta-Mercaptobenzoesäure und para-Mercaptobenzoesäure ausgewählt ist.

9. Photopolymerisierbare Mischung nach Anspruch 5, bei der das Polysulfid Diphenyldisulfid, Dibenzyldisulfid, Di-t-butyldisulfid, Trimethylendisulfid, para-(Phenyldisulfanil)-benzoesäure, Diphenyltrisulfid oder Dibenzyltrisulfid ist.

10. Photopolymerisierbare Mischung nach Anspruch 6, bei der die Monothiophosphorsäureverbindung Trioleylthiophosphat, Tris(2,3-dichlorpropyl)thiophosphat, O,O'-Diethylthiophosphorylchlorid, O,O'-Diiso-

propylthiophosphat oder Natriumdiamylmonothiophosphat ist; der Dithiophosphorsäurediester O,O'-Diethyldithiophosphat, Natriumdipropyldithiophosphat, Zinkdipropyldithiophosphat oder Kupfer-O,O'-di-(2-ethylhexyl)-dithiophosphat ist und der Dithiophosphorsäuretriester O,O'-Di-n-butyl-S-ethyldithiophosphat oder O,O'-Dimethyldithiophosphorylacetat ist.

11. Photopolymerisierbare Mischung nach Anspruch 7, bei der die Triazinverbindungen durch die allgemeine Formel:

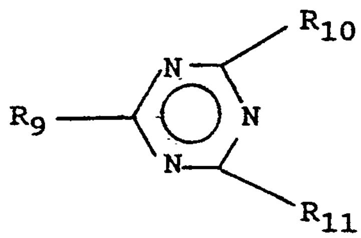

wiedergegeben werden, worin $R_9$, $R_{10}$ und $R_{11}$, unabhängig voneinander, ein Wasserstoffatom, ein Halogenatom, eine Alkylgruppe mit 1 bis 20 Kohlenstoffatomen, eine Hydroxylgruppe, eine Alkoxygruppe mit 1 bis 20 Kohlenstoffatomen, eine Phenoxygruppe, eine Alkylperoxygruppe mit 1 bis 20 Kohlenstoffatomen, eine Aminogruppe, die durch $NR_{12}R_{13}$ (worin $R_{12}$ und $R_{13}$, unabhängig voneinander, ein Wasserstoffatom, eine Alkylgruppe mit 1 bis 20 Kohlenstoffatomen oder eine aromatische Gruppe mit 6 bis 20 Kohlenstoffatomen oder Derivate davon bedeuten) wiedergegeben wird, oder eine Thiogruppe, die durch $SR_{14}$, worin $R_{14}$ ein Wasserstoffatom oder eine Alkylgruppe bedeutet, wiedergegeben wird, bedeuten.

12. Photopolymerisierbare Mischung nach Anspruch 11, bei der die Triazinverbindungen aus 2,4-Bis(n-octylthio)-6-(4-hydroxy-3,5-di-t-butylanilino)-1,3,5-triazin, 2-(N,N-Dibutylamino)-4,6-dimercapto-1,3,5-triazin und 2-Anilino-4,6-dimercapto-1,3,5-triazin ausgewählt sind.

13. Photopolymerisierbare Mischung nach Anspruch 7, bei der die Benzotriazolverbindungen durch die allgemeine Formel:

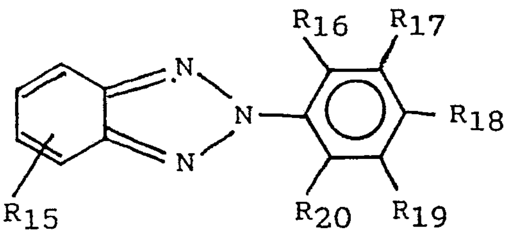

wiedergegeben werden, worin $R_{15}$ ein Wasserstoffatom oder ein Halogenatom bedeutet und $R_{16}$, $R_{17}$, $R_{18}$, $R_{19}$ und $R_{20}$, unabhängig voneinander, ein Wasserstoffatom, eine Hydroxylgruppe, eine Alkylgruppe mit 1 bis 10 Kohlenstoffatomen, eine Benzylgruppe oder Derivate davon bedeuten.

14. Photopolymerisierbare Mischung nach Anspruch 13, bei der die Benzotriazolverbindung mindestens eine Verbindung ist, die aus 2-(5-Methyl-2-hydroxyphenyl)-benzotriazol, 2-[2-Hydroxy-3,5-bis(α,α-dimethylbenzyl)phenyl]-benzotriazol, 2-(3,5-Di-t-butyl-2-hydroxyphenyl)-benzotriazol, 2-(3-t-Butyl-5-methyl-2-hydroxyphenyl)-5-chlorbenzotriazol, 2-(3,5-Di-t-butyl-2-hydroxyphenyl)-5-chlorbenzotriazol und 2-(3,5-Di-t-amyl-2-hydroxyphenyl)-benzotriazol ausgewählt ist.

15. Photopolymerisierbare Mischung nach Anspruch 7, bei der die Oxalsäureanilidverbindung 2-Ethoxy-2'-ethyloxalsäureanilid oder 2-Ethoxy-5-t-butyl-2'-ethyloxalsäurebisanilid ist.

16. Photopolymerisierbare Mischung nach Anspruch 7, bei der die sterisch gehinderte Aminverbindung ein Polykondensat von Dimethyl-1-(2-hydroxyethyl)-4-hydroxy-2,6,6,6-tetramethylpiperidinsuccinat, Poly-(6-(1,1,3,3-tetramethylbutyl)-imino-1,3,5-triazin-2,4-diyl), (2,2,6,6-Tetramethyl-4-piperidyl)-iminohexamethylen-(2,2,6,6-tetramethyl-4-piperidyl)-imin oder (3,5-Di-t-butyl-4-hydroxybenzyl)-2-n-butylmalonsäurebis(1,2,2,6,6-pentamethyl-4-piperidyl) ist.

**17.** Photopolymerisierbare Mischung nach Anspruch 7, bei der die Thiuramsulfidverbindung durch die allgemeine Formel:

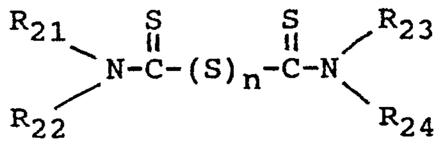

wiedergegeben wird, worin $R_{21}$, $R_{22}$, $R_{23}$ und $R_{24}$, unabhängig voneinander, ein Wasserstoffatom oder eine Alkylgruppe mit 1 bis 10 Kohlenstoffatomen bedeuten und n eine ganze Zahl von 1 bis 4 ist.

**18.** Photopolymerisierbare Mischung nach Anspruch 17, bei der die Thiuramsulfidverbindung mindestens eine Verbindung ist, die aus Tetraethylthiuramdisulfid, Tetramethylthiuramdisulfid und Tetrakis(2-ethylhexyl)thiuramdisulfid ausgewählt ist.